# EUROPÄISCHE PATENTANMELDUNG

(11) **EP 4 579 733 A1**
(43) Veröffentlichungstag der Anmeldung: **02.07.2025**
(21) Anmeldenummer: 23220500.5
(22) Anmeldetag: 28.12.2023
(51) Int. Cl.: H01L 23/427

(54) **ANORDNUNG FÜR EINE ELEKTRONISCHE RECHENEINRICHTUNG MIT ZUMINDEST EINEM LEISTUNGSMODUL, EINEM KÜHLKÖRPER ZUM KÜHLEN DES LEISTUNGSMODULS SOWIE ANORDNUNGSVERBUND**

(71) Anmelder: Siemens Aktiengesellschaft, 80333 München (DE)
(72) Erfinder: Heimann, Matthias, 14469 Potsdam (DE); Müller, Bernd, 16259 Falkenberg (DE); Pfeifer, Markus, 90455 Nürnberg (DE); Stencel, Lisa, 10553 Berlin (DE); Strogies, Jörg, 14163 Berlin (DE)
(74) Vertreter: Siemens Patent Attorneys

(57) **Zusammenfassung**

Die Erfindung betrifft eine Anordnung (10) mit zumindest einem Leistungsmodul (12) und einem Kühlkörper (14) zum Kühlen des Leistungsmoduls (12), wobei das Leistungsmodul (12) mit zumindest einem Leistungschip (16) und mit einer Fügezone (18), auf welcher der Leistungschip (12) angeordnet ist, ausgebildet ist, wobei zwischen dem Leistungsmodul (12) und dem Kühlkörper (14) eine erste Dampfkammereinrichtung (20) ausgebildet ist, wobei zumindest eine Seite (22) der ersten Dampfkammereinrichtung (20) durch das Leistungsmodul (12) begrenzt ist und zumindest eine weitere Seite (24) der ersten Dampfkammereinrichtung (20) durch den Kühlkörper (14) begrenzt ist, und wobei das Leistungsmodul (12) zumindest eine zweite Dampfkammereinrichtung (26) aufweist, welche an einer nochmals weiteren Seite (28) des Leistungschips (16), welche nicht die Unterseite ist, mit einer Wärmeaufnahmeseite der zweiten Dampfkammereinrichtung (26) angeordnet ist, wobei eine Wärmeabgabeseite der zweiten Dampfkammereinrichtung (26) an der Fügezone (18) angeordnet ist. Ferner betrifft die Erfindung ein Anordnungsverbund (50).

## Beschreibung

Die Erfindung betrifft eine Anordnung für eine elektronische Recheneinrichtung mit zumindest einem Leistungsmodul, einem Kühlkörper zum Kühlen des Leistungsmoduls, wobei das Leistungsmodul mit zumindest einem Leistungschip, welcher im Betrieb Wärme erzeugt, und mit einer Fügezone, auf welcher der Leistungschip auf einer Unterseite des Leistungschips angeordnet ist, gemäß dem geltenden Patentanspruch 1. Ferner betrifft die Erfindung einen Anordnungsverbund.

Leistungselektronische Module sind zunehmend durch extreme Leistungsdichten gekennzeichnet. Das bedingt die Herausforderung einer effektiven Abfuhr der entstehenden Verlustwärme. Eine wesentliche Schwachstelle in den Aufbauten besteht im Übergang zwischen dem Leistungsmodul und dem zur konvektiven Wärmeabgabe an Luft notwendigen Kühlkörpern. Diese Grenzflächen stellen allgemein einen limitierenden Faktor dar.

Im Stand der Technik wird diesem Problem beispielsweise durch die Berücksichtigung der Limitierung und entsprechende Auslegungen des Gesamtsystems entgegengetreten. Hierbei wird beispielsweise eine Verlustleistungsdichte begrenzt, oder Wärmeübergangsflächen entsprechend groß ausgebildet. Ferner ist die Anbindung der Module über großflächige Löt- beziehungsweise Sinterverbindungen sowie mit Wärmeleitpasten bekannt. Ferner kann der Kühlkörper, insbesondere im sogenannten Interfacebereich, aus thermisch sehr gut leitfähigen Materialien ausgebildet sein. Ferner sind nicht-übergreifende Oberflächen-Dampfkammereinrichtungen (Vapour Chambers) zur lateralen Wärmespreizung im Kühlkörper bekannt.

Aufgabe der vorliegenden Erfindung ist es, eine Anordnung sowie einen Anordnungsverbund zu schaffen, mittels welchem eine verbesserte Kühlung eines Leistungsmoduls beziehungsweise Leistungschips der Anordnung realisiert werden kann.

Diese Aufgabe wird durch eine Anordnung sowie durch einen Anordnungsverbund gemäß den unabhängigen Patentansprüchen gelöst. Vorteilhafte Ausgestaltungsformen sind in den Unteransprüchen angegeben.

Ein Aspekt der Erfindung betrifft eine Anordnung für eine elektronische Recheneinrichtung mit zumindest einem Leistungsmodul, einem Kühlkörper zum Kühlen des Leistungsmoduls, wobei das Leistungsmodul mit zumindest einem Leistungschip ausgebildet ist, welcher im Betrieb Wärme erzeugt, und mit einer Fügezone, auf welcher der Leistungschip mit einer Unterseite des Leistungschips angeordnet ist.

Es ist dabei vorgesehen, dass zwischen dem Leistungsmodul und dem Kühlkörper eine erste Dampfkammereinrichtung ausgebildet ist, wobei zumindest eine Seite der ersten Dampfkammereinrichtung durch das Leistungsmodul begrenzt ist und zumindest eine weitere Seite der ersten Dampfkammereinrichtung durch den Kühlkörper begrenzt ist, und wobei das Leistungsmodul zumindest eine zweite Dampfkammereinrichtung aufweist, welche einer weiteren Seite des Leistungschips, welche nicht die Unterseite ist, mit einer Wärmeaufnahmeseite der zweiten Dampfkammereinrichtung angeordnet ist, wobei eine Wärmeabgabeseite der zweiten Dampfkammereinrichtung an der Fügezone angeordnet ist.

Somit kann eine verbesserte Kühlung des Leistungsmoduls beziehungsweise des Leistungschips realisiert werden. Insbesondere nutzt dabei die Erfindung die Vorteile der effizienten Entwärmung des Leistungschips über deren Seitenflächen und Oberseiten und die Zusammenführung in einem miniaturisierten Surface-Mount-Device (SMD), beispielsweise als QFN-Bauform mit der nochmaligen Optimierung des Wärmeflusspfades in Richtung des Kühlkörpers durch Eliminierung des separaten Chipmodulträgers. Durch die vorgeschlagenen Lösungen können die Funktionalitäten der bisherigen Chipmodule hinsichtlich mechanischer Trägerfunktion, elektrischer Isolation zwischen lateralen elektrischen Potenzialgebieten und in Richtung Kühlkörper und der effizienten Wärmeübertragung in Richtung Kühlkörper im Wesentlichen in verbesserter Form realisiert werden.

Insbesondere kann somit eine grenzflächenübergreifende erste Dampfkammereinrichtung, welche auch als Vapour Chamber bezeichnet wird, für einen thermisch optimierten Wärmefluss durch die Eliminierung von kontaktbedingten thermischen Widerständen realisiert werden.

Im Stand der Technik, bei welchen das Leistungsmodul nicht stoffschlüssig an den Kühlkörper angebunden wird, können die zu fügenden Oberflächen nur begrenzt angenähert werden, weshalb ein Ausgleichsmedium zur Spaltschließung notwendig wird. Dies wird üblicherweise durch Wärmeleitpasten oder Gap Pads realisiert, welche mit einem erhöhten thermischen Übergangswiderstand sowie einer problematischen Langzeitstabilität der Anbindung durch Alterung und Herauspressen des Materials einhergehen. Die großflächige metallurgische Anbindung durch Löt-/Sinterverbindungen stellt hingegen hohe prozesstechnologische Anforderungen bezüglich Defektarmut (zum Beispiel Vermeidung von Fehlstellen wie Voids). Zudem ist die Stabilität dieser Führung gegenüber thermomechanischen Belastungen kritisch. Die Verwendung von Kühlkörper-Inlays aus Kupfer und Sondermaterialien sowie die Integration von nicht grenzflächenübergreifenden oberflächennahen Vapour Chambers verbessert zwar die Wärmespreizung, nicht aber die zuvor genannten Herausforderungen bezüglich seinem Übergang zwischen den Festkörpergrenzflächen.

Die erfindungsgemäße Lösung bietet eine deutliche Leistungssteigerung durch Adressierung der Gesamtheit der zuvor genannten Problemstellungen. Insbesondere kann erfindungsgemäß durch die grenzübergreifende Vapour Chamber ein optimierter Wärmeübergang zwischen dem Leistungsmodul und dem Kühlkörper realisiert werden.

Insbesondere kann somit eine Eliminierung der Festkörpergrenzflächen durch die Gestaltung einer gemeinsamen Vapour Chamber zwischen Leistungsmodul und Kühlkörper realisiert werden. Des Weiteren liegt eine Verbesserung der lateralen Wärmespreizung durch Ausdehnung der Kondensationsfläche innerhalb des Kühlkörpers vor. Ferner kann auch eine Funktionsintegration der unteren Metallisierungsschicht des Leistungsmoduls durch Gestaltung als obere Halbschale, insbesondere auf der Evaporationsseite, mit entsprechender Topografie realisiert werden. Ferner kann auch eine fertigungsgerechte Gestaltung der Anwendung einer auf den Kühlkörper gefügten Deckplatte realisiert werden.

Bei der Kühlung mithilfe einer Vapour Chamber handelt es sich insbesondere um eine Technik zur Wärmeverteilung, bei der die Verdampfung und Kondensation von Flüssigkeit zur Kühlung einer elektronischen Komponente genutzt wird. Insbesondere wird vorliegend nun die erste Dampfkammereinrichtung mit dem Kühlkörper kombiniert, um den Kühlprozess zu unterstützen.

Bei der Dampfkammereinrichtung handelt es sich somit insbesondere im Grunde um ein flaches Metallgehäuse, das mit einer Dochtstruktur ausgekleidet ist. Die Dampfkammereinrichtung ist dabei beispielsweise mit einer kleinen Menge Flüssigkeit, insbesondere dem Fluid, gefüllt, und vakuumversiegelt. Der niedrige Druck innerhalb der Dampfkammereinrichtung ermöglicht es der Flüssigkeit, bei Temperaturen zu verdampfen, die unter dem normalen Siedepunkt liegen. Wenn die Dampfkammereinrichtung durch eine elektronische Komponente, wie beispielsweise das Leistungsmodul, erhitzt wird, verdampft die Flüssigkeit. Dieser Dampf zirkuliert sodann durch Konvektion und bewegt sich frei durch die Dampfkammereinrichtung. Wenn dies auf eine kühle Oberfläche trifft, insbesondere dem Kühlkörper, kondensiert er und gibt die absorbierte Wärme ab. Die kondensierte Flüssigkeit bewegt sich daraufhin durch das Dochtmaterial und gelangt zurück auf die wärmere Seite. Und dieser Prozess setzt sich dabei fort, solange das elektronische Bauteil, insbesondere das Leistungsmodul, heiß ist.

Ferner ist im Stand der Technik beispielsweise lediglich vorgesehen, dass die Unterseite des Leistungschips entsprechend mit einer Kühlstruktur in Verbindung steht. Erfindungsgemäß ist nun zusätzlich vorgesehen, dass zumindest an einer anderen Seite als der Unterseite die zweite Dampfkammereinrichtung ausgebildet ist, welche mit der Wärmeaufnahmeseite den Leistungschip berührt und somit die Wärme des Leistungschips aufnehmen kann. Mit einer Wärmeabgabeseite ist wiederum die zweite Dampfkammereinrichtung dann mit der Fügezone kontaktiert, welche dann wiederum die Wärme über die Fügezone an beispielsweise eine Kühlstruktur abgeben kann.

Die zweite Dampfkammereinrichtung kann mit der Wärmeaufnahmeseite beispielsweise an dem Leistungschip verklebt sein, beispielsweise mittels Silber(-leitkleber), wodurch auch eine elektrische Kontaktierung zwischen dem Leistungschip und der zweiten Dampfkammereinrichtung realisiert werden kann.

Insbesondere werden somit zusätzliche Wärmepfade vom Leistungschip, welche insbesondere als Leistungshalbleiter bezeichnet werden, additiv zur einseitigen, unterseitigen Kühlung durch die Einbindung der Seitenflächen realisiert. Somit kann eine effiziente Wärmespreizung und -abfuhr durch die Nutzung der zweiten Dampfkammereinrichtung durchgeführt werden. Des Weiteren kann eine verbesserte Wärmeabfuhr in Richtung der Unterseite realisiert werden.

Insbesondere verhindert somit die vorliegende Erfindung, dass beispielsweise auf der Oberseite des Leistungschips beziehungsweise im Wesentlichen in der Nähe der Oberseite des Leistungschips eine weitere Kühlstruktur auszubilden ist. Somit können beispielsweise Packageprobleme des Leistungsmoduls reduziert werden, da die Wärmeabfuhr lediglich über den einen Kühlkörper beziehungsweise die Fügezone zu realisieren ist.

Insbesondere bietet somit die Erfindung eine Kombination der Vorteile der bisherigen einseitigen und beidseitigen Kühlkonzepte. Dadurch kann eine hohe thermische Performance aufgrund multipler Entwärmungspfade bei gleichzeitig einfacher Systemintegration realisiert werden. Der Einsatz der zweiten Dampfkammereinrichtung ermöglicht zudem eine wesentlich effizientere Wärmespreizung und somit eine homogenere Wärmeverteilung und eine schnellere Wärmeabfuhr im Gegensatz zu passiven Materialien.

Erfindungsgemäß ist hier nun vorgeschlagen, dass die Konzepte vereint werden, insbesondere wird eine semi-doppelseitige Kühlung unter Nutzung von ultradünnen Dampfkammereinrichtungen vereint.

Insbesondere bietet somit die Erfindung den Vorteil aus der Kombination aus einer semi-doppelseitigen Kühlung unter Realisierung dieser in einem hochminiaturisierten SMD-Package. Die Nutzung der Isolation durch den Moldkörper für getrennte elektrische Potenzial in Lateralorientierung ist ebenfalls vorgeschlagen. Des Weiteren kann eine Eliminierung des dezidierten Substrats, zum Beispiel DCB-/AMB-Substrat realisiert werden, welches in bestehenden Lösungen den Kompromiss aus elektrischer Isolation und thermischer Leitfähigkeit realisiert, was vorliegend insbesondere anteilig durch einen Moldkörper und durch die Shared-Vapour-Chambers gewährleistet wird. Ferner kann eine Nutzung der gemeinsamen Vapour-Chamber zur optimalen thermischen Anbindung des Packages bei Gewährleistung der elektrischen Isolation im Entwärmungspfad in Richtung des Kühlkörpers realisiert werden.

Gemäß einer vorteilhaften Ausgestaltungsform sind die erste Dampfkammereinrichtung und die zweite Dampfkammereinrichtung fluidisch getrennt zueinander. Insbesondere handelt es sich somit um getrennte und in Reihe geschaltete, chipnahe und Richtung der Kühlkörper orientierte Dampfkammereinrichtungen, wobei kein Medienaustausch zwischen diesen Dampfkammereinrichtungen stattfindet. Somit kann auf einfache Art und Weise eine Herstellung der Anordnung realisiert werden, da die Dampfkammereinrichtungen beispielsweise im Wesentlichen einzeln hergestellt werden können.

Eine weitere vorteilhafte Ausgestaltungsform sieht vor, dass die erste Dampfkammereinrichtung und die zweite Dampfkammereinrichtung fluidisch miteinander verbunden sind. Somit kann eine mit dem Kühlkörper direkt geteilte gemeinsame Dampfkammereinrichtung, insbesondere ausgebildet aus der ersten Dampfkammereinrichtung und der zweiten Dampfkammereinrichtung, bereitgestellt werden, wobei insbesondere die chipnahen Kanäle somit keine eigene Vapour-Chamber bilden, sondern in Richtung des Kühlkörpers offen sind und fluidisch verbunden. Somit kann ein gemeinsames Kühlfluid bereitgestellt werden, sodass eine verbesserte Kühlung des Leistungsmoduls beziehungsweise Leistungschips realisiert werden kann.

Ferner hat es sich als vorteilhaft erwiesen, wenn die zweite Dampfkammereinrichtung den Leistungschip umringt. Insbesondere bildet diese somit einen Ringschluss um den Leistungschip, welcher insbesondere im Wesentlichen quaderförmig ausgebildet ist. Somit kontaktiert die zweite Dampfkammereinrichtung den Leistungschip an den entsprechenden Seitenflächen des Leistungschips, sodass an den Seitenflächen entsprechend Wärme an die zweite Dampfkammereinrichtung abgegeben werden kann. Alternativ kann vorgesehen sein, dass die zweite Dampfkammereinrichtung mehrere einzelne Dampfkammereinrichtungen aufweist, welche den Leistungschip umringen, und beispielsweise einzeln an den Seitenflächen anliegen. Mit anderen Worten kann beispielsweise der Leistungschip von vier einzelnen Dampfkammereinrichtungen umringt sein, welche wiederum als zweite Dampfkammereinrichtung bezeichnet werden können.

Eine weitere vorteilhafte Ausgestaltungsform sieht vor, dass das Leistungsmodul zumindest teilweise als Oberflächen-montierbares Bauteil ausgebildet ist. Das Oberflächen-montierbare Bauteil wird insbesondere auch als Surface-Mounted-Device (SMD) bezeichnet. Bei diesen SMD-Bauelementen handelt es sich insbesondere um Bauelemente der Oberflächenmontage, wobei die gedrahteten Bauelemente keine Drahtanschlüsse, sondern mittels lötfähiger Anschlussflächen oder -beinchen direkt auf eine Leiterplatte gelötet werden können. Die dazugehörige Technik wird auch als Oberflächenmontage (Surface-Mounting Technology SMT) bezeichnet. Hierbei handelt es sich um eine hochperformante Herstellungsmethodik, welche insbesondere den Bau einer Vielzahl von Elementen ermöglicht.

Ebenfalls vorteilhaft ist, wenn ein Leistungsbaustein des Leistungsmoduls als Quad-Flat-No-Leads-Package-Bauteil ausgebildet ist. Hierbei handelt es sich insbesondere um ein sogenanntes QFN-Pack. Dies ist insbesondere als Untergruppe der SMD-Bauteile anzusehen. Die Quad-Flat-No-Leads-Packages werden auch MicroLead-Frame-Packages (MLF) bezeichnet, und ist eine in der Elektronik gebräuchliche Chipgehäusebauform für integrierte Schaltungen. Die Bezeichnung umfasst dabei unterschiedliche Größen von IC (Integrated Circuit)-Gehäusen, welche alle als Oberflächen-montierbare Bauteile auf Leiterplatten gelötet werden. Als wesentliche Merkmale im Gegensatz zu den beispielsweise Quad-Flat-Package (QFP) ragen die elektrischen Anschlüsse, insbesondere die sogenannten Pins, im Wesentlichen nicht seitlich über die Abmessungen der Kunststoffummantelung hinaus, sondern sind in Form von teilverzinnten Kupferanschlüssen in die Unterseite des Gehäuses integriert. Dadurch kann der nötige Platz auf der Leiterplatte reduziert und eine höhere Packungsdichte erreicht werden.

Es hat sich weiterhin als vorteilhaft erwiesen, wenn das Leistungsmodul an einer Leiterplatte der Anordnung angeordnet ist. Somit können beispielsweise elektrische Anschlüsse von der Leiterplatte zu dem Leistungsmodul übertragen werden. Somit können beispielsweise entsprechende Steuersignale für den Leistungschip an den Leistungschip übertragen werden beziehungsweise umgekehrt entsprechende Signale von dem Leistungschip über die Leiterplatte an beispielsweise andere elektronische Komponenten übertragen werden.

In einer weiteren vorteilhaften Ausgestaltungsform ist vorgesehen, dass zwischen dem Leistungsmodul und der Leiterplatte eine Sinterverbindung oder eine Lötverbindung ausgebildet ist. Somit kann eine zuverlässige Verbindung zwischen dem Leistungsmodul und der Leiterplatte realisiert werden. Dabei kann insbesondere eine elektrische Verbindung zwischen der Leiterplatte und dem Leistungsmodul realisiert werden, sodass zuverlässig Steuersignale ausgetauscht werden können.

Ebenfalls vorteilhaft ist, wenn zumindest eine dritte Dampfkammereinrichtung vorgesehen ist, welche an zumindest einem elektrischen Anschluss des Leistungschips angeordnet ist. Beispielsweise kann der Leistungschip Anschlüsse für einen Gate Driver und Source Driver aufweisen. Der Gate Driver und der Source Driver weisen wiederum entsprechende elektrische Anschlüsse auf, welche beispielsweise auf einer Oberseite des Leitungschips angebracht sind. Diese können nun über die dritte Dampfkammereinrichtung beziehungsweise über eine vierte Dampfkammereinrichtung entsprechend ebenfalls mitgekühlt werden, wodurch auch an den entsprechenden Anschlussstellen eine zuverlässige Kühlung realisiert werden kann.

Ferner hat es sich als vorteilhaft erwiesen, wenn zumindest die dritte Dampfkammereinrichtung und die zweite Dampfkammereinrichtung elektrisch voneinander isoliert sind. Insbesondere können somit keine Kurzschlüsse zwischen den elektrischen Anschlüssen stattfinden. Die entsprechenden Isolierungen dienen somit zum Einen zur Funktionsdurchführung und zum Anderen zur elektrischen Sicherheit der Anordnung.

Weiterhin vorteilhaft ist, wenn zumindest die dritte Dampfkammereinrichtung und die zweite Dampfkammereinrichtung räumlich voneinander beabstandet sind. Insbesondere dient dies ebenfalls einer elektrischen Isolation, sodass durch die räumliche Beabstandung keine Kurzschlüsse zwischen den Dampfkammereinrichtungen zu verzeichnen sind. Die räumliche Beabstandung bietet im Wesentlichen die Möglichkeit der Füllung durch Verkapselungsmaterial zur Sicherung der elektrischen Isolation.

Es hat sich weiterhin als vorteilhaft erwiesen, wenn zumindest die erste Dampfkammereinrichtung an der Seite, welche dem Kühlkörper zugewandt ist, Kühlrippen aufweist. Insbesondere die Kühlrippen vergrößern somit die Oberfläche innerhalb der Dampfkammereinrichtung. Durch die Vergrößerung der Oberfläche kann wiederum mehr Wärme von dem Leistungschip beziehungsweise Leistungsmodul über die Dampfkammereinrichtung zum Kühlkörper abgegeben werden. Dies erhöht somit die Erwärmung des Leistungschips über die erste Dampfkammereinrichtung. Zudem können die Kühlrippen geschwungene oder auch säulenförmige Formen annehmen und dienen zusätzlich der Schaffung von Mikrokanälen, um über Kapillarkräfte den Rückfluss kondensierter Flüssigkeit hin zur Evaporationsseite der Dampfkammereinrichtung zu gewährleisten. Zusätzliche Dochtstrukturen oder poröse Oberflächenmodifikationen sind in diesem Falle nicht zwingend erforderlich.

Eine weitere Ausgestaltungsform sieht den Einsatz von Oberflächenbehandlungen der Unterseite des QFN-Packages vor, um unter Generierung einer porösen Topografie eine Dochtstruktur zu schaffen. Diese dient der Rückführung der kondensierten Flüssigkeit hinzu Verdampfungsflächen innerhalb der grenzflächenübergreifenden Dampfkammereinrichtung.

Ein weiterer Aspekt der Erfindung betrifft einen Anordnungsverbund mit zumindest einer ersten Anordnung nach dem vorhergehenden Aspekt und mit einer zweiten Anordnung nach dem vorhergehenden Aspekt, wobei die erste Anordnung und die zweite Anordnung über eine Hauptplatine miteinander gekoppelt sind. Insbesondere kann somit eine Systempartitionierung eines übergeordneten elektronischen Aufbaukonzepts als Anordnungsverbund geschaffen werden unter der Nutzung der vorgeschlagenen Lösung.

Dabei sieht eine vorteilhafte Ausgestaltungsform des Anordnungsverbunds vor, dass die erste Anordnung und die zweite Anordnung einen gemeinsamen Kühlkörper aufweisen. Insbesondere schlägt somit die Erfindung vor, die Systempartitionierung mit einem gemeinsamen Kühlkörper, insbesondere über direkte Montage des PowerQFN mit Shared-Vapour-Chambers auf dem Kühlkörper durchzuführen. Somit kann eine einfache Aufbauform geschaffen werden, um einen Anordnungsverbund entsprechend verbessert kühlen zu können.

Gemäß einer weiteren Ausgestaltungsform des Anordnungsverbunds ist vorgesehen, dass die erste Anordnung und die zweite Anordnung jeweils einen separaten Kühlkörper aufweisen, wobei der Anordnungsverbund einen Hauptkühlkörper aufweist und die jeweiligen Kühlkörper der Anordnungen mit dem Hauptkühlkörper verbunden sind. Somit sind insbesondere im Wesentlichen separate Anordnungen bereitgestellt, welche dann wiederum mit dem Hauptkühlkörper entsprechend verbunden werden können. Beispielsweise kann der Hauptkühlkörper hierzu entsprechende Aufnahmen für die separaten Kühlkörper der jeweiligen Anordnung aufweisen. Dabei können die Kühlkörper aus im Wesentlichen gleichem Material beziehungsweise aus unterschiedlichen Materialen ausgebildet sein. Mit anderen Worten kann auch eine Systempartitionierung in packagenahen Kühlkörpern, insbesondere angeschlossen über die Shared-Vapour-Chamber, bereitgestellt werden, wobei die packagenahen Kühlkörper gegenüber der Vapour-Chamber elektrisch isoliert sind. Die packagenahen Kühlkörper können dann ohne elektrische Isolierung mit dem Hauptkühlkörper gekoppelt sein.

Ein weiterer Aspekt der Erfindung betrifft eine elektronische Recheneinrichtung mit zumindest einer Anordnung und/oder einem Anordnungsverbund nach dem vorhergehenden Aspekt.

Vorteilhafte Ausgestaltungsformen der Anordnung sind als vorteilhafte Ausgestaltungsforme des Anordnungsverbunds und der elektronischen Recheneinrichtung anzusehen.

Unter einer Recheneinheit kann insbesondere ein Datenverarbeitungsgerät verstanden werden, das einen Verarbeitungsschaltkreis enthält. Die Recheneinheit kann also insbesondere Daten zur Durchführung von Rechenoperationen verarbeiten. Darunter fallen gegebenenfalls auch Operationen, um indizierte Zugriffe auf eine Datenstruktur, beispielsweise eine Umsetzungstabelle, LUT (englisch: "look-up table"), durchzuführen.

Die Recheneinheit kann insbesondere einen oder mehrere Computer, einen oder mehrere Mikrocontroller und/oder einen oder mehrere integrierte Schaltkreise enthalten, beispielsweise eine oder mehrere anwendungsspezifische integrierte Schaltungen, ASIC (englisch: "application-specific integrated circuit"), eines oder mehrere feldprogrammierbare Gate-Arrays, FPGA, und/oder eines oder mehrere Einchipsysteme, SoC (englisch: "system on a chip"). Die Recheneinheit kann auch einen oder mehrere Prozessoren, beispielsweise einen oder mehrere Mikroprozessoren, eine oder mehrere zentrale Prozessoreinheiten, CPU (englisch: "central processing unit"), eine oder mehrere Grafikprozessoreinheiten, GPU (englisch: "graphics processing unit") und/oder einen oder mehrere Signalprozessoren, insbesondere einen oder mehrere Digitalsignalprozessoren, DSP, enthalten. Die Recheneinheit kann auch einen physischen oder einen virtuellen Verbund von Computern oder sonstigen der genannten Einheiten beinhalten.

In verschiedenen Ausführungsbeispielen beinhaltet die Recheneinheit eine oder mehrere Hardware- und/oder Softwareschnittstellen und/oder eine oder mehrere Speichereinheiten.

Eine Speichereinheit kann als flüchtiger Datenspeicher, beispielsweise als dynamischer Speicher mit wahlfreiem Zugriff, DRAM (englisch: "dynamic random access memory") oder statischer Speicher mit wahlfreiem Zugriff, SRAM (englisch: "static random access memory"), oder als nicht-flüchtiger Datenspeicher, beispielsweise als Festwertspeicher, ROM (englisch: "read-only memory"), als programmierbarer Festwertspeicher, PROM (englisch: "programmable read-only memory"), als löschbarer programmierbarer Festwertspeicher, EPROM (englisch: "erasable programmable read-only memory"), als elektrisch löschbarer programmierbarer Festwertspeicher, EEPROM (englisch: "electrically erasable programmable read-only memory"), als Flash-Speicher oder Flash-EEPROM, als ferroelektrischer Speicher mit wahlfreiem Zugriff, FRAM (englisch: "ferroelectric random access memory"), als magnetoresistiver Speicher mit wahlfreiem Zugriff, MRAM (englisch: "magnetoresistive random access memory") oder als Phasenänderungsspeicher mit wahlfreiem Zugriff, PCRAM (englisch: "phase-change random access memory"), ausgestaltet sein.

Unabhängig vom grammatikalischen Geschlecht eines bestimmten Begriffes sind Personen mit männlicher, weiblicher oder anderer Geschlechteridentität mit umfasst.

Weitere Merkmale und Merkmalskombinationen der Erfindung ergeben sich aus den Figuren und deren Beschreibung sowie aus den Ansprüchen. Insbesondere müssen weitere Ausführungsformen der Erfindung nicht unbedingt alle Merkmale eines der Ansprüche enthalten. Weitere Ausführungsformen der Erfindungen können Merkmale oder Merkmalskombinationen aufweisen, die nicht in den Ansprüchen genannt sind.

Dabei zeigen:
- FIG 1: eine schematische Seitenansicht einer Ausführungsform einer Anordnung;
- FIG 2: eine weitere schematische Seitenansicht einer weiteren Ausführungsform einer Anordnung;
- FIG 3: eine schematische Seitenansicht einer Ausführungsform eines Anordnungsverbunds; und
- FIG 4: eine weitere schematische Seitenansicht einer weiteren Ausführungsform eines Anordnungsverbunds.

Die Erfindung wird im Folgenden anhand konkreter Ausführungsbeispiele und zugehöriger schematischer Zeichnungen näher erläutert. In den Figuren können gleiche oder funktionsgleiche Elemente mit denselben Bezugszeichen versehen sein. Die Beschreibung gleicher oder funktionsgleicher Elemente wird gegebenenfalls nicht notwendigerweise bezüglich verschiedener Figuren wiederholt.

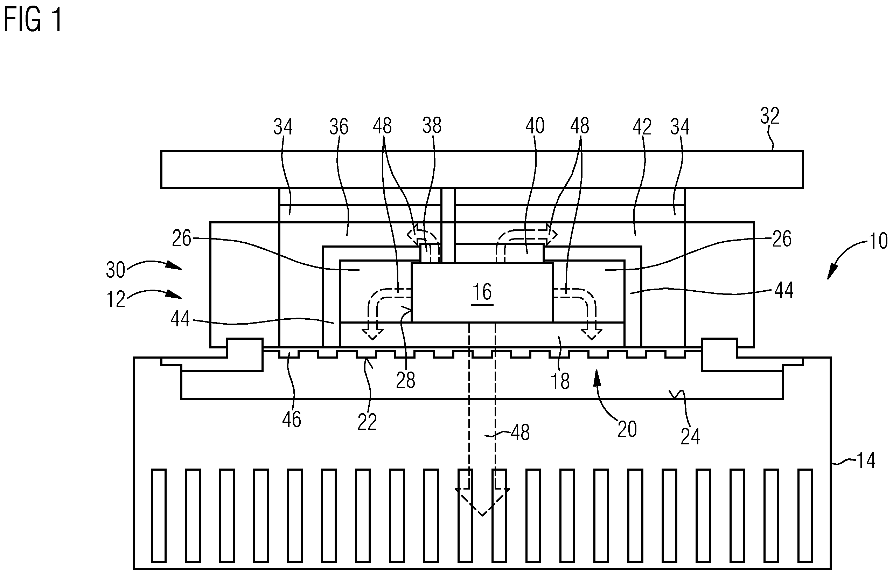

FIG 1 zeigt eine schematische Seitenansicht einer Ausführungsform einer Anordnung 10. Die Anordnung 10 ist für eine elektronische Recheneinrichtung mit zumindest einem Leistungsmodul 12 und einem Kühlkörper 14 ausgebildet. Das Leistungsmodul 12 weist zumindest einen Leistungschip 16 auf, welcher im Betrieb Wärme erzeugt. Ferner ist eine Fügezone 18 gezeigt, auf welcher der Leistungschip 16 mit einer Unterseite des Leistungschips 16 angeordnet ist.

Dabei ist insbesondere vorgesehen, dass zwischen dem Leistungsmodul 12 und dem Kühlkörper 14 eine erste Dampfkammereinrichtung 20 ausgebildet ist, wobei zumindest eine Seite 22 der Dampfkammereinrichtung 20 durch das Leistungsmodul 12 begrenzt ist und zumindest eine weitere Seite 24 der ersten Dampfkammereinrichtung 20 durch den Kühlkörper 14 begrenzt ist, und wobei das Leistungsmodul 12 zumindest eine zweite Dampfkammereinrichtung 26 aufweist, welche an einer nochmals weiteren Seite 28 des Leistungschips 16, welche nicht die Unterseite 22 ist, mit einer Wärmeaufnahmeseite der zweiten Dampfkammereinrichtung 26 angeordnet ist, wobei eine Wärmeabgabeseite der zweiten Dampfkammereinrichtung 26 an der Fügezone 18 ausgebildet ist.

Die FIG 1 zeigt insbesondere, dass die erste Dampfkammereinrichtung 20 und die zweite Dampfkammereinrichtung 26 fluidisch miteinander verbunden sind.

Weiterhin ist es insbesondere vorgesehen, dass die zweite Dampfkammereinrichtung 26 den Leistungschip 16 im Wesentlichen umringt. Ferner ist insbesondere vorgesehen, dass das Leistungsmodul 12 zumindest teilweise als Oberflächen-montierbares Bauteil 30 ausgebildet ist, wobei insbesondere ein Leistungsbaustein des Leistungsmoduls 12 als Quad-Flat-No-Lead-Package-Bauteil ausgebildet ist.

Weiterhin zeigt die FIG 1, dass das Leistungsmodul 12 an einer Leiterplatte 32 der Anordnung 10 angeordnet ist. Dabei kann zwischen dem Leistungsmodul 12 und der Leiterplatte 32 eine Sinterverbindung 34 oder eine Lötverbindung ausgebildet sein.

Ferner zeigt die FIG 1 dass zumindest eine dritte Dampfkammereinrichtung 36 vorgesehen sein kann, welche an zumindest einem elektrischen Anschluss 38 des Leistungschips 16 angeordnet ist. Dabei weist im folgenden Ausführungsbeispiel der Leistungschip 16 einen weiteren elektrischen Anschluss 40 auf, wobei eine vierte Dampfkammereinrichtung 42 mit dem weiteren elektrischen Anschluss 40 kontaktiert ist. Dabei kann insbesondere vorgesehen sein, dass zumindest die dritte Dampfkammereinrichtung 36 und/oder die vierte Dampfkammereinrichtung 42 und die zweite Dampfkammereinrichtung 26 elektrisch voneinander isoliert sind. Insbesondere sind zumindest die dritte Dampfkammereinrichtung 36 und die vierte Dampfkammereinrichtung 42 voneinander elektrisch isoliert. Hierzu kann beispielsweise eine entsprechende Isolationsschicht 44 vorgesehen sein. Des Weiteren kann zumindest die dritte Dampfkammereinrichtung 36 und/oder die vierte Dampfkammereinrichtung 42 und die zweite Dampfkammereinrichtung 26 räumlich voneinander beabstandet sein.

Es ist hierbei insbesondere vorgesehen, dass die dritte Dampfkammereinrichtung 36 und die vierte Dampfkammereinrichtung 42 elektrisch voneinander isoliert sind. Hierzu kann beispielsweise vorgesehen, sein, dass zwischen diesen Dampfkammereinrichtungen 36, 42 ein Moldcompound ausgebildet ist. Vorliegend sind die beiden Dampfkammereinrichtungen somit zwar an der Seite 22 anliegend gezeichnet, sind jedoch tatsächlich elektrisch voneinander isoliert, so dass keine gemeinsame elektrische Kontaktierung über die Seite 22 erfolgt.

Ferner zeigt die FIG 1, dass zumindest die erste Dampfkammereinrichtung 20 an einer Seite, welche dem Kühlkörper 14 zugewandt ist, Kühlrippen 46 aufweisen kann.

In der FIG 1 beziehungsweise in den nachfolgenden Figuren sind entsprechende Entwärmungspfade 48 dargestellt. Diese zeigen insbesondere den Wärmeübertrag von dem Leistungschip 16 in der Richtung des Kühlkörpers 14.

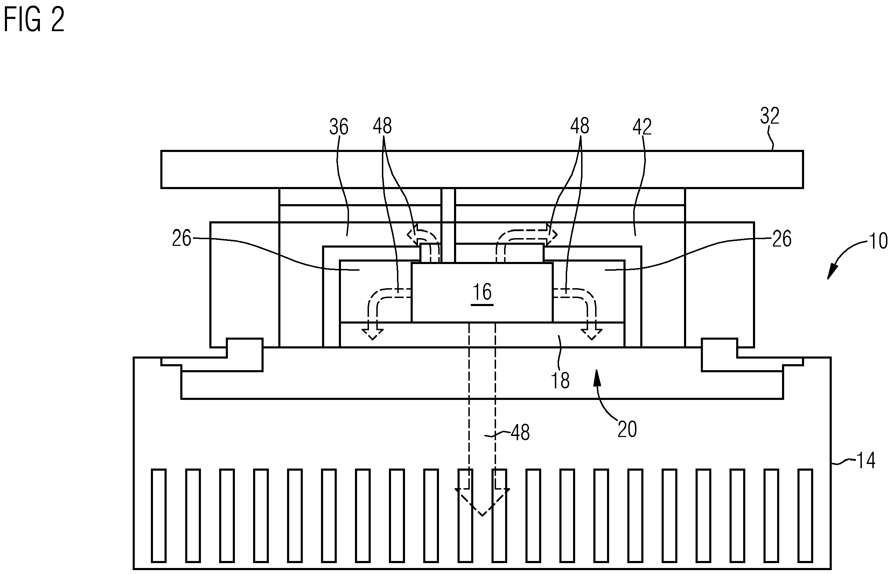

FIG 2 zeigt eine weitere schematische Seitenansicht einer Ausführungsform der Anordnung 10. Im folgenden Ausführungsbeispiel ist insbesondere gegenüber der FIG 1 gezeigt, dass die erste Dampfkammereinrichtung 20 und die zweite Dampfkammereinrichtung 26 fluidisch voneinander getrennt sind. Insbesondere werden somit getrennte und in Reihe geschaltete chipnahe und Richtung des Kühlkörpers 14 orientierte Dampfkammereinrichtungen 20, 26 vorgeschlagen, wobei kein Medienaustausch zwischen diesen Dampfkammereinrichtungen 20, 26 stattfindet.

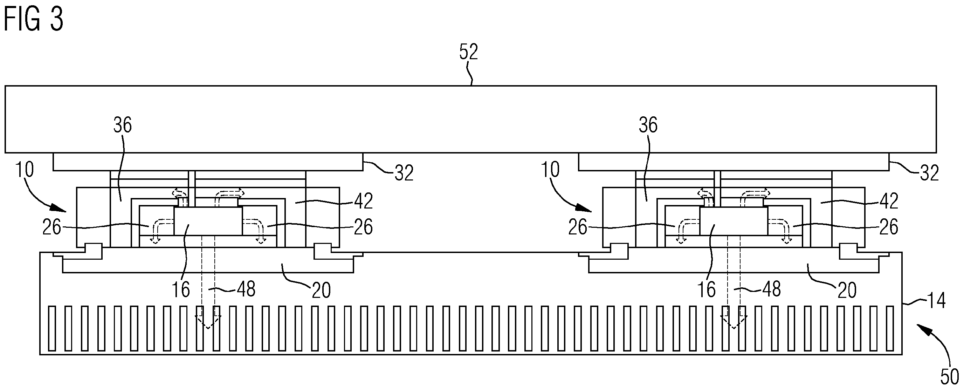

FIG 3 zeigt eine schematische Seitenansicht einer Ausführungsform eines Anordnungsverbunds 50. Dabei weist der Anordnungsverbund 50 zumindest zwei Anordnungen 10 auf. Die Anordnungen 10 sind dabei im folgenden Ausführungsbeispiel im Wesentlichen gleich ausgebildet. Der Anordnungsverbund 50 ist dabei insbesondere für ein übergeordnetes elektronisches Aufbaukonzept vorgeschlagen. Der Anordnungsverbund 50 weist hierzu insbesondere eine Hauptplatine 52 auf, wobei die Anordnungen 10 jeweils mit ihren Leiterplatten 32 an die gemeinsame Hauptplatine 52 angebunden sind.

Im vorliegenden Ausführungsbeispiel ist insbesondere gezeigt, dass der Anordnungsverbund 50 den gemeinsamen Kühlkörper 14 aufweist. Insbesondere ist somit eine Systempartitionierung mit gemeinsamem Kühlkörper 14 vorgeschlagen. Dies ermöglicht insbesondere eine direkte Montage des Leistungsmoduls 12 mit den geteilten Dampfkammereinrichtungen 20, 26 auf dem Kühlkörper 14.

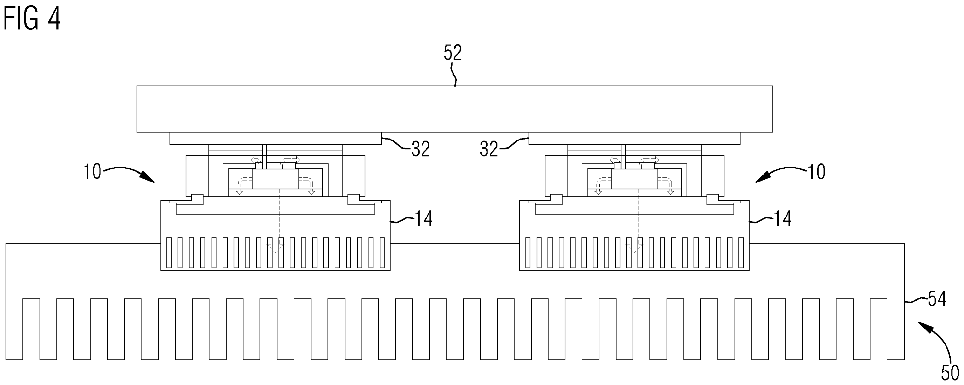

FIG 4 zeigt wiederum eine weitere schematische Seitenansicht einer Ausführungsform eines Anordnungsverbunds 50. Dabei sind die Anordnungen 10 erneut über die Hauptplatine 52 miteinander verbunden. Im folgenden Ausführungsbeispiel weist jedoch jede Anordnung 10 einen separaten Kühlkörper 14 auf. Die separaten Kühlkörper 14 sind wiederum über einen Hauptkühlkörper 54 miteinander gekoppelt. Dabei kann somit eine Systempartitionierung im packagenahen Kühlkörper 14 vorgesehen sein, welche wiederum über die gemeinsamen Dampfkammereinrichtungen 20, 26 miteinander verbunden sind. Dabei beinhalten diese beispielsweise eine elektrische Potenzialtrennung, wobei diese insbesondere beispielsweise über den gemeinsamen Kühlkörper beziehungsweise Hauptkühlkörper 54 durchgeführt werden können. Insbesondere kann auch bei Erforderlichkeit an zum Beispiel den gemeinsamen Kühlkörper beziehungsweise dem Hauptkühlkörper 54 eine weitere elektrische Potenzialtrennung, beispielsweise durch Einpressen, Einlöten oder Sintern, vorgesehen sein. Mit anderen Worten kann auch eine Systempartitionierung in packagenahen Kühlkörpern, insbesondere angeschlossen über die Shared-Vapour-Chamber, bereitgestellt werden, wobei die packagenahen Kühlkörper gegenüber der Vapour-Chamber elektrisch isoliert sind. Die packagenahen Kühlkörper können dann ohne elektrische Isolierung mit dem Hauptkühlkörper gekoppelt sein.

### Bezugszeichenliste

- 10: Anordnung
- 12: Leistungsmodul
- 14: Kühlkörper
- 16: Leistungschip
- 18: Fügezone
- 20: erste Dampfkammereinrichtung
- 22: Seite
- 24: weitere Seite
- 26: zweite Dampfkammereinrichtung
- 28: nochmals weitere Seite
- 30: Oberflächen-montierbares Bauteil
- 32: Leiterplatte
- 34: Sinterverbindung
- 36: dritte Dampfkammereinrichtung
- 38: elektrischer Anschluss
- 40: weiterer elektrischer Anschluss
- 42: vierte Dampfkammereinrichtung
- 44: elektrische Isolation
- 46: Kühlrippen
- 48: Entwärmungspfad
- 50: Anordnungsverbund
- 52: Hauptplatine
- 54: Hauptkühlkörper

## Patentansprüche

1. Anordnung (10) für eine elektronische Recheneinrichtung mit zumindest einem Leistungsmodul (12) und einem Kühlkörper (14) zum Kühlen des Leistungsmoduls (12), wobei das Leistungsmodul (12) mit zumindest einem Leistungschip (16), welcher im Betrieb Wärme erzeugt, und mit einer Fügezone (18), auf welcher der Leistungschip (12) mit einer Unterseite des Leistungschips (16) angeordnet ist, ausgebildet ist,
**dadurch gekennzeichnet, dass**
zwischen dem Leistungsmodul (12) und dem Kühlkörper (14) eine erste Dampfkammereinrichtung (20) ausgebildet ist, wobei zumindest eine Seite (22) der ersten Dampfkammereinrichtung (20) durch das Leistungsmodul (12) begrenzt ist und zumindest eine weitere Seite (24) der ersten Dampfkammereinrichtung (20) durch den Kühlkörper (14) begrenzt ist, und wobei das Leistungsmodul (12) zumindest eine zweite Dampfkammereinrichtung (26) aufweist, welche an einer nochmals weiteren Seite (28) des Leistungschips (16), welche nicht die Unterseite ist, mit einer Wärmeaufnahmeseite der zweiten Dampfkammereinrichtung (26) angeordnet ist, wobei eine Wärmeabgabeseite der zweiten Dampfkammereinrichtung (26) an der Fügezone (18) angeordnet ist.

2. Anordnung (10) nach Anspruch 1, **dadurch gekennzeichnet,**
**dass**
die erste Dampfkammereinrichtung (20) und die zweite Dampfkammereinrichtung (26) fluidisch getrennt sind.

3. Anordnung (10) nach Anspruch 1, **dadurch gekennzeichnet,**
**dass**
die erste Dampfkammereinrichtung (20) und die zweite Dampfkammereinrichtung (26) fluidisch miteinander verbunden sind.

4. Anordnung (10) nach einem der vorhergehenden Ansprüche,
**dadurch gekennzeichnet, dass**
die zweite Dampfkammereinrichtung (26) den Leistungschip (16) umringt.

5. Anordnung (10) nach einem der vorhergehenden Ansprüche,
**dadurch gekennzeichnet, dass**
das Leistungsmodul (12) zumindest teilweise als Oberflächen-montierbares Bauteil ausgebildet ist.

6. Anordnung (10) nach Anspruch 5, **dadurch gekennzeichnet,**
**dass**
ein Leistungsbaustein (30) des Leistungsmoduls (12) als Quad-Flat-No-Leads-Package Bauteil ausgebildet ist.

7. Anordnung (10) nach einem der vorhergehenden Ansprüche,
**dadurch gekennzeichnet, dass**
das Leistungsmodul (12) an einer Leiterplatte (32) der Anordnung (10) angeordnet ist.

8. Anordnung (10) nach Anspruch 7, **dadurch gekennzeichnet,**
**dass**
zwischen dem Leistungsmodul (12) und der Leiterplatte (32) eine Sinterverbindung (34) oder eine Lötverbindung ausgebildet ist.

9. Anordnung (10) nach einem der vorhergehenden Ansprüche,
**dadurch gekennzeichnet, dass**
zumindest eine dritte Dampfkammereinrichtung (36) vorgesehen ist, welche an zumindest einem elektrischen Anschluss (38) des Leistungschips (16) angeordnet ist.

10. Anordnung (10) nach Anspruch 9, **dadurch gekennzeichnet,**
**dass**
zumindest die dritte Dampfkammereinrichtung (36) und die zweite Dampfkammereinrichtung (26) elektrisch voneinander isoliert sind.

11. Anordnung (10) nach einem der vorhergehenden Ansprüche,
**dadurch gekennzeichnet, dass**
zumindest die dritte Dampfkammereinrichtung (36) und die zweite Dampfkammereinrichtung (26) räumlich voneinander beabstandet sind.

12. Anordnung (10) nach einem der vorhergehenden Ansprüche,
**dadurch gekennzeichnet, dass**
zumindest die erste Dampfkammereinrichtung (20) an einer Seite, welche dem Kühlkörper (14) zugewandt ist, Kühlrippen (46) aufweist.

13. Anordnungsverbund (50) mit zumindest einer ersten Anordnung (10) nach einem der Ansprüche 1 bis 12 und einer zweiten Anordnung (10) nach einem der Ansprüche 1 bis 12, wobei die erste Anordnung (10) und die zweite Anordnung (10) über eine Hauptplatine (52) miteinander gekoppelt sind.

14. Anordnungsverbund (50) nach Anspruch 13, **dadurch gekennzeichnet, dass**
die erste Anordnung (10) und die zweite Anordnung (10) einen gemeinsamen Kühlkörper (14) aufweisen.

15. Anordnungsverbund (50) nach Anspruch 13, **dadurch gekennzeichnet, dass**
die erste Anordnung (10) und die zweite Anordnung (10) jeweils einen separaten Kühlkörper (14) aufweisen, wobei der Anordnungsverbund (50) einen Hauptkühlkörper (54) aufweist und die jeweiligen Kühlkörper (14) der Anordnungen (10) mit dem Hauptkühlkörper (54) verbunden sind.
